# EUROPEAN PATENT SPECIFICATION

(11) **EP 2 429 060 B1**
(45) Date of publication and mention of the grant of the patent: **14.05.2014**
(21) Application number: 10075401.9
(22) Date of filing: 09.09.2010
(51) Int. Cl.: H02J 13/00, G06F 1/26, H05K 7/14, H04L 12/10

(54) **A power distribution unit with oscilloscope function**
Stromverteilungseinheit mit Oszilloskop-Funktion
Unité de distribution d'alimentation avec fonction d'oscilloscope

(43) Date of publication of application: 14.03.2012
(73) Proprietor: Racktivity NV, 9080 Lochristi (BE)
(72) Inventor: Ingels, Wilbert, 1741 Ternat (Wambeek) (BE); Vinken, Niko, 8570 Anzegem (BE)
(74) Representative: Plas, Axel Ivo Michel

(56) References cited:
- WO-A1-03/025898
- WO-A1-2009/086485
- US-A1- 2003 004 660
- US-A1- 2008 317 021

## Description

### Field of the Invention

The present invention generally relates to power distribution and management in data centres and server installations. In particular, the present invention concerns a power distribution unit (PDU) with improved graphical representation of various measured parameters such as currents, voltages, power, harmonics, etc. Improved graphical representation of these measured parameters helps in detecting for instance power supply or server hardware failures, and consequentially also in preventing abnormal shutdowns (disaster prevention) and recovering from an abnormal power shutdown (disaster recovery).

### Background of the Invention

Data centres represent hosting facilities that typically host a few tens up to thousands of servers, routers, switches, etc., generally named "computers" throughout this patent application. In a data centre, these computers are organized in racks or cabinets. Power has become one of the most difficult and expensive items to manage in such data centres. Up to 40 % of data centre power supplies are not working optimally. These power supplies consume excessive power resulting in heating, malfunctioning devices, and finally occasional or regular power shutdowns. Networks are out of control after a power failure in the data centre and often customers are aware of the data centre problem before the data centre's operator. In 50 % of the cases, the data centre operator is informed by the customer on a power shutdown that has occurred in the data centre. It is therefore of utmost importance to design and develop power distribution systems for data centres with enhanced functionality for measuring and monitoring certain parameters in order to better predict and prevent power supply failures.

As opposed to a dumb power distribution unit (PDU) that has no instrumentation and is not manageable, the present invention concerns a smart power distribution unit, also named a "data centre management unit" or DCMU that can be metered, is equipped with one or more displays, and preferably can be switched, i.e. individual outlets can be switched on or off remotely. Smart PDUs typically feature serial data ports such as RS232 ports or USB (Universal Serial Bus) ports for controlling hardware in the data room like for example servers, switches, routers, etc. In addition, smart PDUs typically have a port for network connectivity such as an RJ45 interface for Ethernet connectivity. This way, the data centre administrator is enabled to access the smart PDU from a remote terminal or PC with network connectivity in order to turn on/off certain outlets, to schedule power shutdowns, to control the load, etc.

Although several PDUs exist that measure various parameters such as the incoming voltage or current per outlet, there are no existing PDUs that support adequate graphical representation of the behaviour of such parameters. At best, existing PDU's average these parameters over a time interval of 1 second or more, e.g. by calculating the RMS or TrueRMS value of such parameter, and show the calculated value in multi-meter view.

International Patent Application WO 2009/086485 entitled "Power Distribution, Management, and Monitoring Systems and Methods" for instance discloses a smart PDU (20 in Fig. 2 of WO 2009/086485) with a power inlet (32 in Fig. 2) and a plurality of power outlets (40 in Fig. 2) for distributing power to servers in a data center (see paragraphs [0004] and [0005] of WO 2009/086485). The PDU known from WO 2009/086485 further measures a number of parameters through sensors (52, 56, 60, 64 in Fig. 2) and graphically displays certain parameters like the power usage (1201 in Fig. 17). The PDU known from WO 2009/086485 however does not provide an oscilloscope view of certain parameters, i.e. a time and/or frequency domain view of the full signal, sampled at microsecond level.

The advertisement "Remote Metered Power Distribution PDU Monitor Server" from Ambery retrievable from the internet via the URL: http://www.ambery.com/remepodipdum.html for instance describes an IP-addressable PDU with built-in web server allowing the administrator to remotely obtain a multi-meter view of the metered current, average power consumption, temperature and humidity levels through a local network or the internet using a web browser from a remote PC. Only true RMS values of the monitored parameters are visible in the screenshots shown in this advertisement.

Similarly, the 115V 15A 20A 30A power distribution unit from Network Technologies Inc, advertised on the internet at URL: http://www.networktechinc.com/remote-power.html describes an intelligent PDU that monitors voltage and current, and that generates alerts using e-mail or SNMP traps when the monitored currents exceed certain ranges. This intelligent PDU is equipped with a web interface enabling to access the measured RMS values through a web browser. Again, the screen shots shown in the advertisement indicate that only true RMS values of the monitored parameters are accessible for display in multi-meter view.

US Patent Application 2009/0070611 entitled "Managing Computer Power Consumption in a Data Center", describes a state-of-the-art method for preventing power shutdown disasters in data centre (disaster prevention). In the known method, the aggregate power consumption of a plurality of computers in the data centre is monitored and as soon as the aggregate power consumption exceeds a predetermined threshold, certain computers are throttled down in order of priority.

The PDU known from US 2009/0070611 calculates the aggregate power consumption. Although not explicitly mentioned, this PDU at best may be assumed to support display of this calculated aggregate power consumption in multi-meter view.

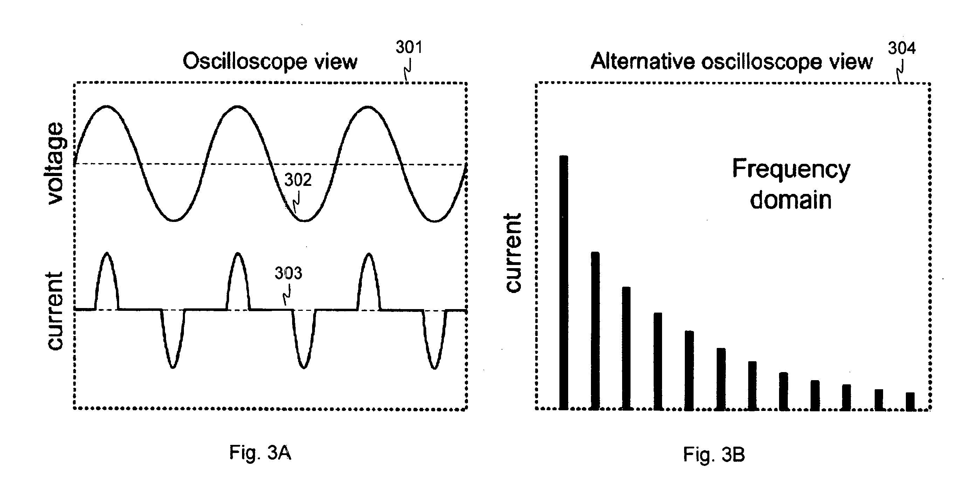

Yet another patent application, US 2009/0228726 entitled "Environmentally Cognizant Power Management" discloses another smart PDU - 305 in Fig. 3 - with real-time electrical metering of the consumed power at server level. The PDU known from US 2009/0228726 further is equipped with sensors for measuring environmental parameters such as temperature, humidity and airflow in order to dynamically control the applications and tasks running on the different servers for power usage optimization in the data centre.

Although a number of parameters are metered, the PDU known from US 2009/0228726 does not enable oscilloscope view of these parameters in frequency domain and/or time domain.

In order to show the time domain or frequency domain representation of certain parameters in oscilloscope view, a straightforward solution would be to connect an oscilloscope to each power outlet of the PDU. Examples of such oscilloscopes and the working thereof are described for instance in Wikipedia at the URL: http://en.wikipedia.org/wiki/Oscilloscope As is mentioned at Wikipedia, oscilloscopes are commonly used to observe the exact wave shape of an electrical signal. In addition to the amplitude of the signal, an oscilloscope can show distortion, the time between two events (such as pulse width, period, or rise time) and relative timing of two related signals. This straightforward solution could for instance be realised with a power distribution system like the one disclosed in United States Patent US 7,138,815 entitled "Power Distribution System Built-In Self Test Using On-Chip Data Converter". The power distribution system disclosed in this patent is equipped with analogue electronic output circuitry, e.g. 34' in Fig. 2B of US 7,138,815, that can be coupled to an external oscilloscope. Connecting an external oscilloscope to each power outlet of a PDU however is too cumbersome, too expensive, and too voluminous. In case plural PDUs need to be monitored, the situation is even worse.

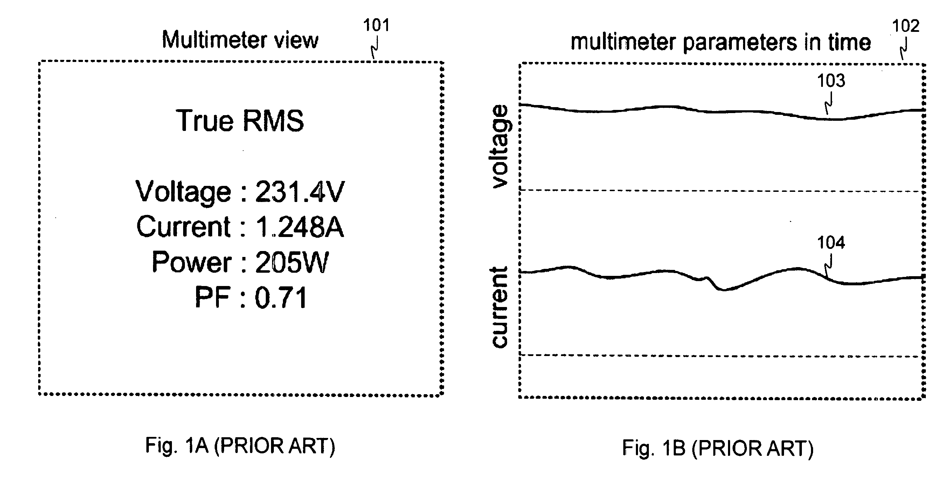

In summary, existing PDUs do not support oscilloscope view of metered parameters in time or frequency domain, and as a result thereof do not enable to adequately prevent disaster situations where plural servers, racks or the entire data centre are affected by a power shutdown. At best, existing PDUs calculate averaged values of current, voltage, power, etc. and show these averaged values as soon as they are calculated, in multi-meter view (Fig. 1A and Fig. 1 B). In Europe, the averaged voltage, i.e. the RMS or TrueRMS value, for instance will approximate +225V irrespective of the point in time, whereas the value of the voltage could range between -300V and +300V. Dependent on the points in time of the samples, the voltage could for instance be +50V at timestamp 0 and -290V at timestamp x.

Such multi-meter view is known from metering equipment like the power consumption meter reader known from United States Patent Application US 2003/0004660 entitled "Method and Apparatus for Reading and Controlling Electric Power Consumption". Therein, a web-based application is described that enables an end-user to remotely monitor the power consumption through graphs or charts depicted in his/her browser. The consumed power that is depicted in the graphs, obviously represents TrueRMS or RMS values of the power consumption, i.e. the power consumption typically averaged over seconds, or even hours or billing cycles as is indicated by paragraph [0040] of US 2003/0004660. No exact waveforms or oscilloscope views are offered to the end user since such views would not be interpretable and meaningless to an end user who likes to monitor the power consumption of certain house appliances.

It is an objective of the present invention to disclose a PDU that overcomes the above identified shortcomings of existing PDUs.

### Summary of the Invention

According to the present invention, the above identified shortcomings of the prior art are resolved through the power distribution unit (PDU) for controlling power distribution to computers in a data centre as defined by claim 1, the power distribution unit (PDU) comprising at least one power inlet, a plurality of power outlets for providing power to respective ones of the computers, at least one sensor for sensing at least one parameter, and a processor enabling graphical representation of the at least one parameter, the at least one sensor being enabled to sample the at least one parameter at microsecond level, and the processor being adapted to enable oscilloscope view graphical representation of the at least one parameter in time domain and/or frequency domain comprising representation of the at least one parameter's harmonics.

Thus, the invention concerns a PDU with integrated oscilloscope function such that the entire measured signal, i.e. both amplitude and phase of for instance voltage or current or power, can be graphically represented in time domain (Fig. 3A) or frequency domain (Fig. 3B), or both. Instead of the straightforward but costly solution of connecting to each inlet and outlet an external oscilloscope, the current invention introduces an integrated oscilloscope function for PDUs that memorizes and transforms the measured parameters into a time domain and/or frequency domain representation. For a time domain representation, digital, time-stamped samples of the parameter(s) of interest may be made available. For frequency domain representation, the parameter samples have to be transformed first, using for instance FFT or DWT algorithms. This time and/or frequency domain representation can be made accessible through an integrated web server in the PDU such that the oscilloscope function becomes remotely accessible through a browser. Alternatively, the integrated oscilloscope function may be used by a display in the PDU itself to visualize the time domain and/or frequency domain representation of one or more parameters. Yet another alternative consists in providing in the PDU an interface towards an external display.

As is further specified by claim 2, the at least one parameter may comprise one or more of the following:
- an incoming voltage;
- a voltage per power outlet;
- a voltage per incoming phase of a multi-phase power inlet;
- a current per power outlet;
- a sum of currents for the plurality of power outlets;
- a power value per power outlet; and
- a sum of power values for the plurality of power outlets.

Optionally, as defined by claim 3, the PDU according to the present invention may comprise a timestamp unit adapted to timestamp samples of the at least one parameter, and an output interface to output the samples and corresponding timestamps for graphical representation.

Thus, in case only an oscilloscope view in time domain of certain parameters is desired, it is sufficient to timestamp digital samples of the parameters of interest and to make these timestamped samples available via a digital output.

Optionally, as is defined by claim 4, the PDU according to the present invention may comprise one or more of the following:
- a Fourier transformer; and
- a Wavelet transformer.

A PDU with integrated Fourier transformer will enable graphical representation of the parameters in frequency domain. This way, harmonics of the incoming voltage, current, power, etc. may be visualized. A PDU with integrated Wavelet transformer will enable graphical representation of the parameters in both time domain and frequency domain, which brings the advantage that one can also retrieve the point in time where certain harmonics took place. The skilled technician however will appreciate that the Fourier Transform or Wavelet Transform are only examples. Any other existing or future transformation that transforms signal samples between time domain and frequency domain could be integrated in the PDU according to the present invention. It is noticed that the presence of a Fourier transformer or Wavelet transformer may be combined with the presence of a timestamp unit that timestamps samples of parameters in order to enable a real-time oscilloscope view of the time domain representation of certain parameters.

Further optionally, as defined by claim 5, the power distribution unit (PDU) according to the present invention may comprise a processor for calculating one or more of the following factors:
- a K-factor;
- a total harmonic distortion or THD;
- a phase shift between current and voltage;
- a phase shift between current and voltage for each harmonic;
- a crest factor.

Indeed, with access to the time domain and/or frequency domain representation of parameters such as the individual currents per port and the incoming voltage, these factors can be determined at server level. The K-factor, which is a weighting of the harmonic load currents indicative for the harmonics' heating effects, for instance may be useful for selecting transformers used in the data centre. The crest factor represents the ratio of peak value and RMS value for a parameter.

According to another optional aspect, defined by claim 6, the power distribution unit (PDU) according to the invention may comprise an alerting unit for generating alerts when either:
- one or more of the parameters exceed certain thresholds;
- one or more of the parameters follow certain patterns;
- a ratio between parameter values exceeds a certain threshold; or
- a ratio between parameter values follows a certain pattern.

Indeed, thanks to the integrated oscilloscope function, patterns of a signal in time or frequency can be monitored. These patterns may be used to trigger events such as sending of alerts.

As is indicated by claim 7, the power distribution unit (PDU) according to the invention further optionally may comprise a memory for logging the one or more parameters.

As is indicated by claim 8, the power distribution unit (PDU) according to the invention further optionally may comprise a memory for logging one or more of the calculated factors.

Also optionally, as defined by claim 9, the memory for logging may be adapted to log the parameters for a time interval between 10 milliseconds and multiple minutes, for instance 10 minutes between start and stop of the logging.

Typically, in order to be useful for the integrated oscilloscope function, parameters will be logged for a number of cycles. The current or voltage with cycle period of e.g. 20 milliseconds (assuming a 50 Hz power supply) may for instance be logged for 4 periods, i.e. 80 milliseconds.

### Brief Description of the Drawings

Fig. 1A and Fig. 1 B illustrate multi-meter views made available through prior art power distribution units;
Fig. 2 illustrates an embodiment of the power distribution unit (PDU) according to the present invention; and
Fig. 3A and Fig. 3B illustrate oscilloscope views made available through a power distribution unit (PDU) according to the present invention.

### Detailed Description of Embodiment(s)

In Fig. 1A, a traditional multi-meter view 101 is depicted. The multi-meter view displays on a screen a number of averaged values, in this case the TrueRMS values calculated for the voltage, i.e. 231.4 Volts, the current, i.e. 1.248 Ampères, the power, i.e. 205 Watts, and the power factor, i.e. 0.71 of one particular outlet. The evolution of these TrueRMS values in time may also be depicted, as is illustrated by Fig. 1 B. The multi-meter view 102 shown there contains the evolution in time of the averaged voltage 103 and current 104. The multi-meter view which is typically available on prior art PDUs fails to provide an oscilloscope view of the monitored parameters.

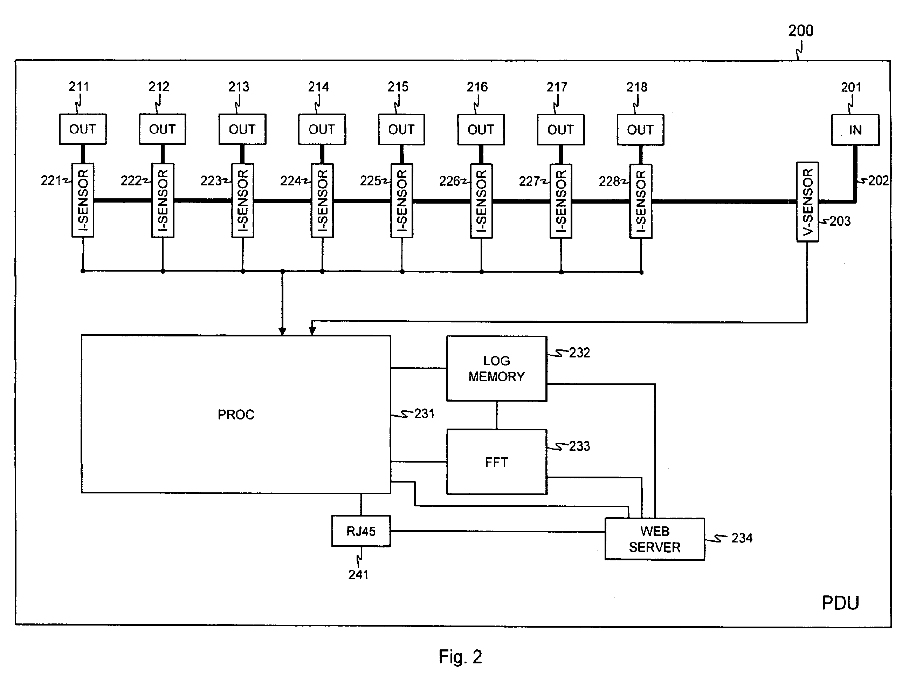

Fig. 2 shows a power distribution unit, PDU or 200. The PDU has a single power inlet, IN or 201, eight power outlets, OUT or 211, 212, 213, 214, 215, 216, 217 and 218, a processor, PROC or 231, a memory, LOG MEMORY or 232, and an RJ45 connector 241. The RJ45 connector 241 is connected to the processor 231. Each of the power outlets 211, 212, 213, 214, 215, 216, 217 and 218 is equipped with a current sensor, respectively denoted by I-SENOR or 221, 222, 223, 224, 225, 226, 227 and 228. The current sensors 221, 222, 223, 224, 225, 226, 227 and 228 are connected to an input of the processor 231. At the power inlet 201, the PDU 200 is equipped with a voltage sensor, V-SENSOR or 203, placed in the power distribution wiring 202. The latter power distribution wiring 202, represented by a bold, black line in Fig. 2, couples the power outlets 211, 212, 213, 214, 215, 216, 217 and 218 to the power inlet 201 via respective switch-on/switch-off circuits, not drawn in Fig. 2. Fig. 2 further shows a Fast Fourier Transformer, FFT or 233 and a web server, WEB SERVER or 234.

The PDU 200 drawn in Fig. 2 can distribute power to at most eight connected devices. The power inlets of these eight devices, e.g. servers in a rack of a data center, thereto are connected to the power outlets 211, 212, 213, 214, 215, 216, 217 and 218 of the PDU 200. By controlling the switch-on/switch-off circuits, the processor 231 controls the distribution of power to the servers connected to the outlets 211, 212, 213, 214, 215, 216, 217 and 218. When the power outlet 211 is switched off, the server connected to power outlet 211 is de-activated. When the power outlet 211 is switched on, the server connected to the power outlet 211 is activated. The current sensor 221 then measures the current delivered via outlet 211. The current sensor 221 thereto samples the current 400 times per cycle, i.e. at a sampling rate of 400 x 50 Hz or 20.000 samples per second. The samples are stored in the log memory 232.

The PDU 200 is remotely configurable and controllable via a network, e.g. the Internet. Via remote management, certain power outlets can be switched on/off, rebooting servers can be scheduled, certain ports on servers, routers, switches can be turned off/on, etc. by the data center operator without disposing a technician to the data center. The network connectivity is realized through the RJ45 Ethernet connector 241 drawn in Fig. 2. Typically, this RJ45 connector will be connected via one or more firewalls and/or routers to the Internet or an Intranet, and enable the data center operator to remotely manage and control the power distribution from a PC with network connectivity.

The log memory 232 logs the values of different parameters and eventually also the occurrence of certain events. In the PDU of Fig. 2, the voltage sensed by voltage sensor 203 is logged, and the current delivered to the different outlets and sensed by the current sensors 221, 222, 223, 224, 225, 226, 227 and 228, is also logged. Voltage and current per outlet are sampled at a sampling rate of 20.000 samples per second (50 Hz x 400 samples per cycle period). The memory 232 logs the values over a time period of at least 10 milliseconds to multiple minutes. The samples are timestamped by processor 231 before being stored in the log memory 232.

The processor 231 maintains a number of predetermined or configurable thresholds, like an upper and lower threshold for the overall power consumption, an upper and lower threshold for the individual power consumption per outlet, etc. Exceeding such a threshold (eventually by a certain percentage and/or for a certain period of time) represents an event that may also be logged by the memory 232. The memory 232 can be implemented as RAM, PROM, or a combination of both like for instance a fast small FRAM for short term logging and a slow big EEPROM for long term logging.

The Fast Fourier Transformer 233 transforms a selection of samples of one or more of the logged parameters into frequency domain such that also the complete frequency domain representation of the signal becomes accessible through web server 234. The web server 234 also has access to the complete time domain representation of parameters of interest, stored in the log memory 232. As an alternative to the Fast Fourier Transformer, a Discrete Wavelet Transformer could be integrated in the PDU in order to make both frequency domain and time domain representation of a signal available via the web server 234. Other transformations could be considered as well. Although the Fast Fourier Transformer 233 has been drafted as a separate entity or processor in Fig. 2, it is noticed that the Fourier transformation could alternatively be executed by the processor 231 as well, provided this processor 231 has sufficient capacity.

The frequency domain representation and/or time domain representation of the measured currents and voltages may further be exploited by the processor 231 or another processor in the PDU in order to determine when phase shifts took place, or to calculate certain factors such as the K-factor, the total harmonic distortion, the crest factor, etc. These factors may also be made accessible through the web server 234. When these factors, or the time domain or frequency domain pattern, or the ratio between certain parameter values or parameter patterns shows discrepancies that exceed certain thresholds or ranges, events such as the sending of alerts may be triggered.

Fig. 3A shows one example of an oscilloscope view 301 wherein the behavior of the voltage 302 and current 303 in the time domain is represented. Such oscilloscope view may be made available through a PDU according to the present invention. Another PDU according to the present invention may also enable representation of certain parameters like the current, voltage and power in frequency domain. An example oscilloscope view 304 made available through such a PDU is shown in Fig. 3B.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A power distribution unit (PDU, 200) for controlling power distribution to computers in a data center, said power distribution unit (PDU, 200) comprising at least one power inlet (IN, 201), a plurality of power outlets (OUT, 211, 212, 213, 214, 215, 216, 217, 218) for providing power to respective ones of said computers, at least one sensor (203, 221, 222, 223, 224, 225, 226, 227, 228) for sensing at least one parameter, and a processor (233, 234) enabling graphical representation (301, 304) of said at least one parameter
**CHARACTERIZED IN THAT**
said at least one sensor are enabled to sample said at least one parameter at microsecond level, and
said processor (233, 234) is adapted to enable oscilloscope view graphical representation (301, 304) of said at least one parameter in time domain and/or frequency domain comprising representation of said at least one parameter's harmonics.

2. A power distribution unit (PDU, 200) according to claim 1, **CHARACTERIZED IN THAT** said at least one parameter comprises one or more of the following:
- an incoming voltage;
- a voltage per power outlet (OUT, 211, 212, 213, 214, 215, 216, 217, 218);
- a voltage per incoming phase of a multi-phase power inlet;
- a current per power outlet (OUT, 211, 212, 213, 214, 215, 216, 217, 218);
- a sum of currents for said plurality of power outlets (OUT, 211, 212, 213, 214, 215, 216, 217, 218);
- a power value per power outlet (OUT, 211, 212, 213, 214, 215, 216, 217, 218); and
- a sum of power values for said plurality of power outlets (OUT, 211, 212, 213, 214, 215, 216, 217, 218).

3. A power distribution unit (PDU, 200) according to claim 1,
**CHARACTERIZED IN THAT** said power distribution unit (PDU, 200) further comprises a timestamp unit adapted to timestamp samples of said at least one parameter, and an output interface to output said samples and corresponding timestamps for graphical representation.

4. A power distribution unit (PDU, 200) according to claim 1,
**CHARACTERIZED IN THAT** said power distribution unit (PDU, 200) comprises one or more of the following:
- a Fourier transformer (233); and
- a Wavelet transformer.

5. A power distribution unit (PDU, 200) according to claim 1,
**CHARACTERIZED IN THAT** said power distribution unit (PDU, 200) further comprises a processor (231) for calculating one or more of the following factors:
- a K-factor;
- a total harmonic distortion or THD;
- a phase shift between current and voltage;
- a phase shift between current and voltage for each harmonic;
- a crest factor.

6. A power distribution unit (PDU, 200) according to claim 1 or claim 5,
**CHARACTERIZED IN THAT** said power distribution unit (PDU, 200) further comprises an alerting unit for generating alerts when either:
- one or more of said parameters or said factors exceed certain thresholds;
- one or more of said parameters or said factors follow certain patterns;
- a ratio between parameter values exceeds a certain threshold; or
- a ratio between parameter values follows a certain pattern.

7. A power distribution unit (PDU, 200) according to claim 1,
**CHARACTERIZED IN THAT** said power distribution unit (PDU, 200) further comprises a memory (232) for logging said one or more parameters.

8. A power distribution unit (PDU, 200) according to claim 5,
**CHARACTERIZED IN THAT** said power distribution unit (PDU, 200) further comprises a memory (232) for logging one or more of said factors.

9. A power distribution unit (PDU, 200) according to claim 7 or claim 8,
**CHARACTERIZED IN THAT** said memory (232) for logging is adapted to log said parameters for a time interval between 10 milliseconds and 10 minutes.

## Patentansprüche

1. Leistungsverteilungseinheit (PDU, 200) zur Steuerung der Leistungsverteilung an Computer in einem Datenzentrum, wobei die Leistungsverteilungseinheit (PDU, 200) mindestens einen Leistungseinlass (EIN, 201), eine Vielzahl von Leistungsauslässen (AUS, 211, 212, 213, 214, 215, 216, 217, 218) zur Bereitstellung von Leistung an die Entsprechenden der Computer, mindestens einen Sensor (203, 221, 222, 223, 224, 225, 226, 227, 228) zum Abtasten mindestens eines Parameters und einen Prozessor (233, 234) umfasst, der die graphische Darstellung (301, 304) des mindestens einen Parameters ermöglicht,
**dadurch gekennzeichnet, dass**
der mindestens eine Sensor dazu in der Lage ist, den mindestens einen Parameter auf der Ebene einer Mikrosekunde zu testen, und
der Prozessor (233, 234) ausgelegt ist, um eine graphische Anzeige der Oszilloskopansicht (301, 304) des mindestens einen Parameters in der Zeitdomäne und/oder in der Frequenzdomäne zu ermöglichen, umfassend die Darstellung der Harmonischen des mindestens einen Parameters.

2. Leistungsverteilungseinheit (PDU, 200) nach Anspruch 1,
**dadurch gekennzeichnet, dass** der mindestens eine Parameter eines oder mehrere der Folgenden umfasst:
- eine Eingehende Spannung;
- eine Spannung pro Leistungsauslass (AUS, 211, 212, 213, 214, 215, 216, 217, 218);
- eine Spannung pro eingehender Phase eines mehrphasen-Leistungseinlasses;
- ein Strom pro Leistungsauslass (AUS, 211, 212, 213, 214, 215, 216, 217, 218);
- eine Summe von Strömen für die Vielzahl von Leistungsauslässen (AUS, 211, 212, 213, 214, 215, 216, 217, 218);
- einen Leistungswert pro Leistungsauslass (AUS, 211, 212, 213, 214, 215, 216, 217, 218); und
- eine Summe Leistungswerten für die Vielzahl von Leistungsauslässen (AUS, 211, 212, 213, 214, 215, 216, 217, 218).

3. Leistungsverteilungseinheit (PDU, 200) nach Anspruch 1,
**dadurch gekennzeichnet, dass** die Leistungsverteilungseinheit (PDU, 200) weiter eine Zeitstempeleinheit umfasst, die für Zeitstempelproben des mindestens einen Parameters ausgelegt ist, und eine Ausgabeschnittstelle, um die Proben und die entsprechenden Zeitstempel für die graphische Darstellung auszugeben.

4. Leistungsverteilungseinheit (PDU, 200) nach Anspruch 1,
**dadurch gekennzeichnet, dass** die Leistungsverteilungseinheit (PDU, 200) mindestens eines oder mehrere der Folgenden umfasst:
- eine Fourier-Transformation (233); und
- eine Wavelet-Transformation.

5. Leistungsverteilungseinheit (PDU, 200) nach Anspruch 1,
**dadurch gekennzeichnet, dass** die Leistungsverteilungseinheit (PDU, 200) weiter einen Prozessor (231) umfasst, um einen oder mehrere der folgenden Faktoren zu berechnen:
- einen K-Faktor;
- eine totale harmonische Verzerrung oder THD;
- eine Phasenverschiebung zwischen Strom und Spannung;
- eine Phasenverschiebung zwischen Strom und Spannung für jede Harmonische;
- einen Scheitelfaktor.

6. Leistungsverteilungseinheit (PDU, 200) nach Anspruch 1 oder Anspruch 5,
**dadurch gekennzeichnet, dass** die Leistungsverteilungseinheit (PDU, 200) weiter eine Warneinheit umfasst, um Warnungen zu erzeugen, wenn entweder:
- einer oder mehrere der Parameter oder der Faktoren bestimmte Schwellen übersteigen;
- einer oder mehrere der Parameter oder der Faktoren bestimmten Mustern folgen;
- in Verhältnis zwischen den Parameterwerten eine bestimmte Schwelle übersteigt; oder
- ein Verhältnis zwischen Parameterwerten einem bestimmten Muster folgt.

7. Leistungsverteilungseinheit (PDU, 200) nach Anspruch 1,
**dadurch gekennzeichnet, dass** die Leistungsverteilungseinheit (PDU, 200) weiter einen Speicher (232) umfasst, um den einen oder die mehreren Parameter aufzuzeichnen.

8. Leistungsverteilungseinheit (PDU, 200) nach Anspruch 5,
**dadurch gekennzeichnet, dass** die Leistungsverteilungseinheit (PDU, 200) weiter einen Speicher (232) umfasst, um einen oder mehrere der Faktoren aufzuzeichnen.

9. Leistungsverteilungseinheit (PDU, 200) nach Anspruch 7 oder Anspruch 8,
**dadurch gekennzeichnet, dass** der Speicher (232) zur Aufzeichnung ausgelegt ist, um die Parameter für ein Zeitintervall zwischen 10 Millisekunden und 10 Minuten aufzuzeichnen

## Revendications

1. Unité de distribution d'énergie (PDU, 200) pour commander une distribution d'énergie à des ordinateurs dans un centre de données, ladite unité de distribution d'énergie (PDU, 200) comprenant au moins une entrée d'énergie (IN, 201), une pluralité de sorties d'énergie (OUT, 211, 212, 213, 214, 215, 216, 217, 218) pour fournir de l'énergie à des ordinateurs respectifs parmi lesdits ordinateurs, au moins un capteur (203, 221, 222, 223, 224, 225, 226, 227, 228) pour détecter au moins un paramètre, et un processeur (233, 234) permettant une représentation graphique (301, 304) dudit au moins un paramètre,
**caractérisée en ce que**
ledit au moins un capteur est activé pour échantillonner ledit au moins un paramètre au niveau d'une microseconde, et
ledit processeur (233, 234) est apte à permettre une représentation graphique de vue d'oscilloscope (301, 304) dudit au moins un paramètre dans le domaine de temps et/ou dans le domaine de fréquence comprenant une représentation des harmoniques dudit au moins un paramètre.

2. Unité de distribution d'énergie (PDU, 200) selon la revendication 1,
**caractérisée en ce que** ledit au moins un paramètre comprend une ou plusieurs de ce qui suit :
- une tension entrante ;
- une tension par sortie d'énergie (OUT, 211, 211, 213, 214, 215, 216, 217, 218) ;
- une tension par phase entrante d'une entrée d'énergie multiphasée ;
- une intensité par sortie d'énergie (OUT, 211, 211, 213, 214, 215, 216, 217, 218) ;
- une somme des intensités pour ladite pluralité de sorties d'énergie (OUT, 211, 211, 213, 214, 215, 216, 217, 218) ;
- une valeur d'énergie par sortie d'énergie (OUT, 211, 211, 213, 214, 215, 216, 217, 218) ; et
- une somme des valeurs d'énergie pour ladite pluralité de sorties d'énergie (OUT, 211, 211, 213, 214, 215, 216, 217, 218).

3. Unité de distribution d'énergie (PDU, 200) selon la revendication 1,
**caractérisée en ce que** ladite unité de distribution d'énergie (PDU, 200) comprend en outre une unité d'horodatage apte à horodater des échantillons dudit au moins un paramètre, et une interface de sortie pour délivrer lesdits échantillons et des horodatages correspondants pour une représentation graphique.

4. Unité de distribution d'énergie (PDU, 200) selon la revendication 1,
**caractérisée en ce que** ladite unité de distribution d'énergie (PDU, 200) comprend un ou plusieurs de ce qui suit :
- un transformateur de Fourier (233) ; et
- un transformateur d'ondelette.

5. Unité de distribution d'énergie (PDU, 200) selon la revendication 1,
**caractérisée en ce que** ladite unité de distribution d'énergie (PDU, 200) comprend en outre un processeur (231) pour calculer un ou plusieurs des facteurs suivants :
- un facteur K ;
- une distorsion totale d'harmoniques ou THD ;
- un déphasage entre l'intensité et la tension ;
- un déphasage entre l'intensité et la tension pour chaque harmonique ;
- un facteur de crête.

6. Unité de distribution d'énergie (PDU, 200) selon la revendication 1 ou 5,
**caractérisée en ce que** ladite unité de distribution d'énergie (PDU, 200) comprend en outre une unité d'alerte pour générer des alertes lorsque :
- un ou plusieurs desdits paramètres ou desdits facteurs dépassent certains seuils ;
- un ou plusieurs desdits paramètres ou desdits facteurs suivent certains motifs ;
- un rapport entre des valeurs de paramètres dépasse un certain seuil ; ou
- un rapport entre des valeurs de paramètres suit un certain motif.

7. Unité de distribution d'énergie (PDU, 200) selon la revendication 1,
**caractérisée en ce que** ladite unité de distribution d'énergie (PDU, 200) comprend en outre une mémoire (232) pour enregistrer lesdits un ou plusieurs paramètres.

8. Unité de distribution d'énergie (PDU, 200) selon la revendication 5,
**caractérisée en ce que** ladite unité de distribution d'énergie (PDU, 200) comprend en outre une mémoire (232) pour enregistrer un ou plusieurs desdits facteurs.

9. Unité de distribution d'énergie (PDU, 200) selon la revendication 7 ou 8,
**caractérisée en ce que** ladite mémoire (232) pour l'enregistrement est apte à enregistrer lesdits paramètres pendant un intervalle de temps entre 10 millisecondes et 10 minutes.
